# EUROPÄISCHE PATENTSCHRIFT

(11) **EP 3 655 786 B1**
(45) Veröffentlichungstag und Bekanntmachung des Hinweises auf die Patenterteilung: **25.06.2025**
(21) Anmeldenummer: 18779287.4
(22) Anmeldetag: 19.09.2018
(51) Int. Cl.: G01R 31/12

(54) **VERFAHREN UND ANORDNUNG ZUM ERKENNEN VON TEILENTLADUNGEN BEI EINEM ELEKTRISCHEN BETRIEBSMITTEL**
METHOD AND ARRANGEMENT FOR DETECTING PARTIAL DISCHARGES IN AN ELECTRIC OPERATING MEANS
PROCÉDÉ ET SYSTÈME D'IDENTIFICATION DE DÉCHARGES PARTIELLES DANS UNE RESSOURCE ÉLECTRIQUE

(30) Priorität: 20.09.2017 DE 102017216644
(43) Veröffentlichungstag der Anmeldung: 27.05.2020
(73) Patentinhaber: Siemens Energy Global GmbH & Co. KG, 81739 München (DE)
(72) Erfinder: WIEDENBAUER, Anton, 91809 Wellheim (DE)
(86) Internationale Anmeldenummer: PCT/EP2018/075266
(87) Internationale Veröffentlichungsnummer: WO 2019/057735

(56) Entgegenhaltungen:
- WO-A1-96/07925
- US-A1- 2004 246 000

## Beschreibung

Die Erfindung betrifft ein Verfahren gemäß dem Oberbegriff des Anspruchs 1 sowie eine Anordnung gemäß dem Oberbegriff des Anspruchs 6.

Gasisolierte Schaltanlagen sind aus der Produktbroschüre "Gasisolierte Schaltanlagen, Baureihe 8DN8 bis 170 kV, 63 kA, 4000 A" der Siemens AG, 2011, Bestell-Nr. E50001-G620-A122-V1, bekannt. Bei einer Zustandsüberwachung von gasisolierten Schaltanlagen (GIS) liegt das Hauptaugenmerk auf der Erkennung von Teilentladungen (TE), da diese bei den meisten Fehlerszenarien auftreten. Das Mittel der Wahl ist die Detektion der TE mittels Messung elektromagnetischer Wellen, die sich bei jeder TE in der GIS ausbreiten. Diese werden typischerweise im Ultrahochfrequenzbereich (UHF-Bereich) erfasst, der sich von einigen hundert MHZ bis wenigen GHz im Frequenzspektrum befindet.

Im Falle einer TE treten elektromagnetische Impulse typischerweise mehrfach pro Sinuswelle (der Netzspannung, z.B. 50Hz) auf. Diese Impulse sind breitbandig, werden aber durch die GIS bauartbedingt in einigen Frequenzbereichen mehr gedämpft als in anderen. Der ideale Frequenzbereich zur Erfassung von TE variiert daher für GIS unterschiedlichen Typs. Ein Verfahren zur Zustandsüberwachung muss TE sicher erfassen und deswegen sensitiv genug sein, die elektromagnetischen Impulse der zu überwachenden GIS erfassen zu können. Um dies sicher zu stellen wird das System bei Inbetriebnahme mittels eines sog. Kalibrators eingestellt. Der Kalibrator kann, z.B. einen elektromagnetischen ReferenzImpuls bereitstellen, um das Verfahren bzw. die entsprechende Anordnung zum Erkennen von Teilentladungen zu kalibrieren.

Ein typisches Setup eines UHF-TE-Monitoring Systems besteht aus Filterkomponenten, einer Signalverstärkung und einem Analog-Digital-Wandler, der schnell und präzise ein 12 Bit Signal erzeugen kann. Ferner wird eine Störsignalfilterung und eine Fehlerursachenerkennung nach dem sog. Point-on-Wave Analyseverfahren durchgeführt. Es werden zusätzlich eine Datenspeicherung, eine Visualisierung und Kommunikationsprotokolle benötigt. Die zugrundeliegende Hard- und Software wird teilweise bis zu sechsmal pro Feld eingesetzt. Dies ergibt sich daraus, dass z.B. bei einer dreiphasigen Ausführung einer GIS mit einphasiger Kapselung für jede Phase jeweils vor und nach einem Leistungsschalter eine Messeinrichtung für TE benötigt wird. Das Resultat des bisherigen Ansatzes sind komplexe und teure Systeme, die für technische Experten eine direkte Analyse der Fehlerursache und Fehlerschwere erlauben.

Beispielsweise ist ein digitales Zustandsüberwachungssystem für GIS unter dem Markennamen "Assetquard PDM" aus der Produktbroschüre "Assetguard Switchgear Condition Monitoring - Integriertes Substation Condition Monitoring (ISCM^{®}) für HS-Schaltanlagen", Siemens AG 2012, Auftragsnr.: IC1000-G240-A100-X-4A00, bekannt. Auch aus der Dissertation "Teilentladungsmessung im Gigahertz-Frequenzbereich an SF6-isolierten Schaltanlagen" von Rolf Kurrer aus dem Jahr 1997, Institut für Energieübertragung und Hochspannungstechnik der Universität Stuttgart, ISBN 3-8265-2211-7, sind Verfahren zur Auswertung von UHF-Signalen für eine Erkennung von Teilentladungen in GIS bekannt.

Andere bisher bekannte Ansätze nutzen eine akustische Überwachung im Hinblick auf bei Teilentladungen entstehende Geräusche oder analysieren chemische Veränderungen im Isoliergas, die bei Teilentladungen auftreten.

Die WO 96/07925 A1 betrifft ein Verfahren zum Bestimmen transienter Teilentladungen im Isoliermedium eines elektrischen Leistungstransformators. Die US 2004/246000 A1 betrifft ein Verfahren zur Erkennung von Teilentladungen und Diagnosesystem für elektrische Geräte.

Ausgehend von dem bisher bekannten Verfahren zum Erkennen von Teilentladungen bei einem elektrischen Betriebsmittel mittels UHF Auswertung stellt sich an die Erfindung die Aufgabe, ein Verfahren anzugeben, das vergleichsweise einfach und kostengünstig ist.

Die Erfindung löst diese Aufgabe durch ein Verfahren gemäß Anspruch 1.

Es ist ein Vorteil der Erfindung, dass ein elektromagnetischer Impuls einer TE schmalbandig gefiltert, verstärkt und mit einer einstellbaren Referenzspannung verglichen wird. Dieses vereinfachte Verfahren ermöglicht eine Umsetzung mit analogen Schaltungen, was gegenüber den bisher eingesetzten digitalen Systemen wesentlich kostengünstiger und zuverlässiger ist. Ferner ist es vorteilhaft, dass die Auswertung des schmalbandigen Signals deutlich einfacher möglich ist als eine Analyse eines breitbandigen UHF-Signals, wie es bisher im Stand der Technik üblich war.

Da das erfindungsgemäße Verfahren als ein reiner Indikator für das Vorliegen von Teilentladungen konzipiert ist, ist es akzeptabel, wenn nicht jeder TE-Impuls erkannt wird. Signifikante TE-Impulse treten bei Vorliegen eines Fehlers in einer GIS z.B. mehrmals pro 50Hz Periode auf. Daher ist es ausreichend, eine Teilentladung in einer akzeptablen Zeit von beispielsweise einer Sekunde zu erkennen. Beispielsweise kann das System bei der Installation so kalibriert werden, dass es Fehlalarme vermeidet. Es kann z.B. eine einfache Ein-Punkt-Kalibrierung erfolgen, was vergleichsweise kostengünstig und schnell durchgeführt werden kann.

Im Gegensatz zu bisherigen Verfahren wird eine Teilentladung also rein quantitativ bestimmt und als Ja/Nein Information über das Vorliegen von Teilentladungen ausgegeben. Anstatt wie bisher das Signal breitbandig zu verarbeiten, wird erfindungsgemäß ein schmalbandiger Filter eingesetzt. Dieser schmalbandige Filter ermöglicht auf einfache Weise eine vergleichsweise gute Störunterdrückung. Eine schnelle und präzise Analog-Digital-Wandlung und Auswertung von Signalen mit einem digitalen Signalprozessor ist nicht erforderlich.

In einer bevorzugten Ausführungsform des erfindungsgemäßen Verfahrens werden als Sensoreinrichtungen interne und/oder externe Antennen zum Empfang von elektromagnetischen Signalen verwendet. Die intern und extern empfangenen UHF-Signale werden jeweils in gleicher, erfindungsgemäßer Weise ausgewertet. Kommt ein mittels einer internen Antenne erkanntes TE-Signal auch in den empfangenen UHF Signalen einer zugeordneten externen Antenne vor, so handelt es sich um eine von außen einwirkende Störung und nicht um eine in der GIS vorkommende TE. Ein solches als äußere Störeinwirkung erkanntes Signal wird folglich nicht als Teilentladung gewertet und bei einer weiteren Auswertung nicht berücksichtigt.

In einer bevorzugten Ausführungsform des erfindungsgemäßen Verfahrens wird das Signal einer erkannten Teilentladung mittels eines Kippstufenausgangs in ein digitales Signal umgewandelt. Die Referenzspannung wird vorher so eingestellt, dass die elektronische Kippstufe bei eingespeistem Referenzimpuls zuverlässig schaltet. Dies ist ein Vorteil, weil die Komplexität des Signals weiter vereinfacht wird. Ein digitales Signal bedeutet, dass bei Erkennung einer Teilentladung beispielsweise eine Spannung mit vorgegebener Höhe ausgegeben wird und bei keiner Erkennung einer Teilentladung keine Spannung ausgegeben wird.

In einer bevorzugten Ausführungsform des erfindungsgemäßen Verfahrens wird Kippstufenausgang ein Schmitt-Trigger verwendet. Dies ist ein Vorteil, weil sog. Schmitt-Trigger in der analogen Schaltungstechnik lange erprobt und verbreitet sind.

In einer bevorzugten Ausführungsform des erfindungsgemäßen Verfahrens wird ein Halteglied zum Verlängern der Zeitdauer des digitalen Signals eingesetzt. Das nachgeschaltete Halteglied verlängert die Dauer eines detektierten Impulses so, dass z.B. mechanische Schaltelemente zum Anzeigen einer TE Aktivität eingesetzt werden können.

In einer bevorzugten Ausführungsform des erfindungsgemäßen Verfahrens werden für die Sensoreinrichtung, die Filtereinrichtung, die Verstärkereinrichtung, den Kippstufenausgang, das Halteglied und die Auswerteeinrichtung jeweils analoge elektrische Schaltungen verwendet. Dies ist ein Vorteil, weil analoge Schaltungen besonders kostengünstig und langlebig sind.

In einer bevorzugten Ausführungsform des erfindungsgemäßen Verfahrens werden die elektromagnetischen Impulse in einem Frequenzbereich bis 2 GHz erfasst und für das schmale Frequenzband wird eine Frequenzbreite von höchstens 200 MHz verwendet.

Ferner stellt sich ausgehend von bisher bekannten Anordnungen zum Erkennen von Teilentladungen bei einem elektrischen Betriebsmittel mittels UHF Auswertung an die Erfindung die Aufgabe, eine Anordnung anzugeben, die vergleichsweise einfach und kostengünstig zur Überwachung einer GIS einsetzbar ist.

Die Erfindung löst diese Aufgabe durch eine Anordnung gemäß Anspruch 6. Bevorzugte Ausführungsformen ergeben sich aus den abhängigen Ansprüchen 7 bis 10. Dabei ergeben sich für die erfindungsgemäße Anordnung und ihre Ausführungsformen sinngemäß die gleichen Vorteile wie eingangs für das erfindungsgemäße Verfahren erläutert.

Zur besseren Erläuterung der Erfindung zeigt in schematischer Darstellung die
- Figur 1: ein Beispiel für eine Verteilung von Teilentladungen bei einer GIS, und
- Figur 2: ein Ausführungsbeispiel des erfindungsgemäßen Verfahrens, und
- Figur 3: ein erstes Ausführungsbeispiel für den Einsatz interner und externer Antennen bei einer GIS, und
- Figur 4: ein zweites Ausführungsbeispiel für den Einsatz interner und externer Antennen bei einer GIS, und
- Figur 5: ein drittes Ausführungsbeispiel für den Einsatz interner und externer Antennen bei einer GIS, und
- Figur 6: ein viertes Ausführungsbeispiel für den Einsatz interner und externer Antennen bei einer GIS.

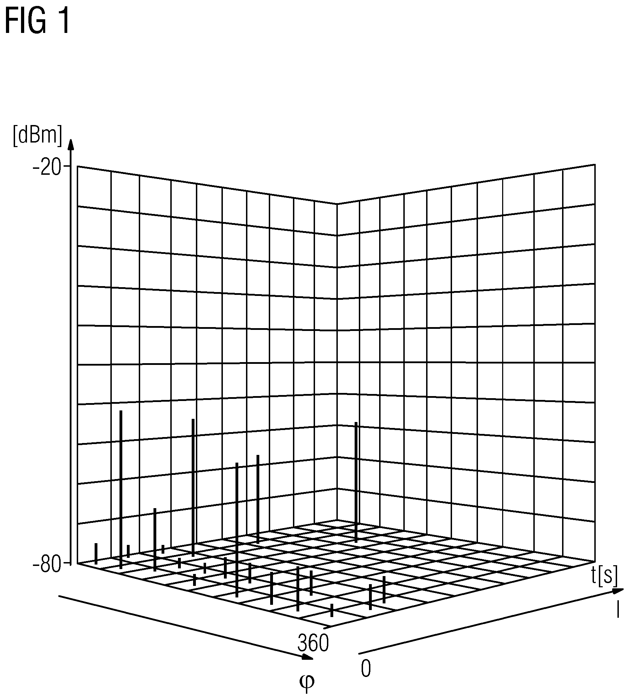

Die Figur 1 zeigt ein Beispiel für eine Verteilung von Teilentladungen bei einer gasisolierten elektrischen Schaltanlage. Auf der z-Achse ist die Amplitude, auf der x-Achse der Phasenwinkel φ und auf der y-Achse die Zeit in Sekunden aufgetragen. Die Abbildung zeigt, dass bei einer realen gasisolierten Schaltanlage Teilentladungen bei bestimmten Phasenwinkeln gehäuft auftreten. Dies gibt dem Fachmann einen Hinweis darauf, an welchem Teil der gasisolierten elektrischen Anlage intern Teilentladungen auftreten. Typischerweise treten Teilentladungen bei GIS mehrmals pro Stunde auf, wenn ein Fehler in der Schaltanlage vorliegt. Bei modernen GIS sollten im Normalbetrieb trotz der vergleichsweise kompakten Bauweise mit kleinen Isolationsabständen keine Teilentladungen auftreten.

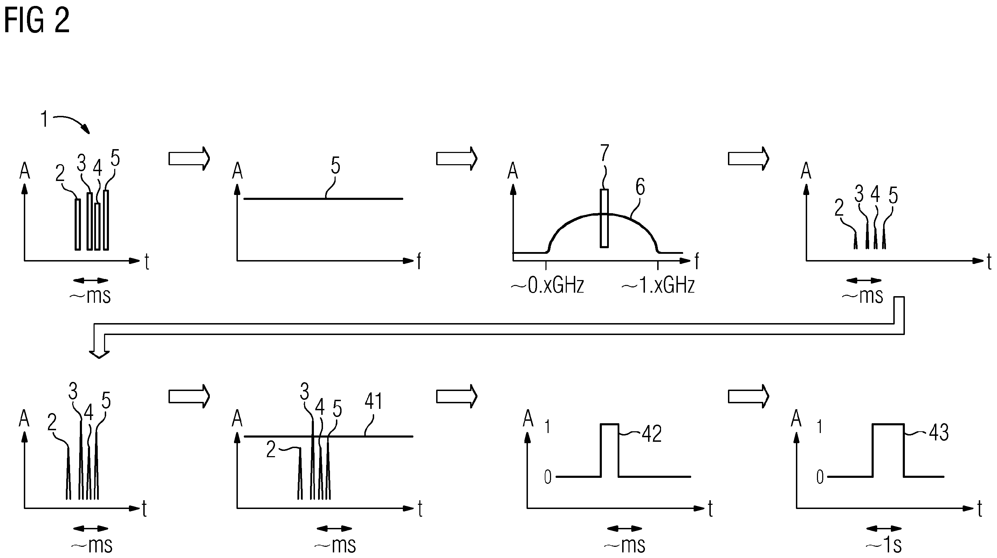

Die Figur 2 zeigt ein Ausführungsbeispiel des erfindungsgemäßen Verfahrens 1. Dargestellt sind einzelne Verfahrensschritte, wobei auf der nach oben orientierten Achse die Amplitude jeweils durch den Buchstaben A gekennzeichnet ist. Beginnend links oben in der Abbildung treten vier elektromagnetische Impulse 2,3,4,5 im Millisekundenbereich auf. Die Impulse 2,3,4,5 werden z.B. mittels eines Sensors bzw. einer internen Antenne in der GIS gemessen.

Im nächsten Schritt ist ein einzelner dieser Impulse 5 im Frequenzbereich dargestellt. Es ist zu erkennen, dass der Impuls 5 sehr breitbandig, d. h. über ein großes Frequenzspektrum, vorliegt.

Im dritten Bild von links ist zu erkennen, dass der vorliegende Einzelimpuls 5 aus dem vorherigen Bild eine Dämpfung erfährt. Die Dämpfung ergibt sich bauartbedingt durch die gasisolierte Schaltanlage und die verwendete Antenne (bzw. den Sensor), die den elektromagnetischen Impuls aufnimmt. Im dargestellten Beispiel werden Frequenzen im sehr niedrigen GHz-Bereich und im Bereich über 1 GHz im Wesentlichen durch die Bauart der gasisolierten Schaltanlage und der Antenne gedämpft. Im Bereich einiger 100 MHz jedoch liegt das Signal mit großer Amplitude und nur geringer Dämpfung vor, was schematisch durch einen halbkreisförmigen Bogen 6 angedeutet ist. In diesem gering gedämpften Bereich 6 wird ein schmalbandiger Filter 7 eingesetzt. Der schmalbandige Filter 7 isoliert einen Frequenzanteil des elektromagnetischen Impulses 5 für eine weitergehende Analyse. Typischerweise ist die Frequenzbreite des schmalbandigen Filters geringer als 300 MHz, bevorzugt geringer als 200 MHz und noch mehr bevorzugt geringer als 100 MHz angesetzt.

Das vierte Bild von links in der ersten Reihe zeigt, dass die vier ursprünglichen Impulse 2, 3, 4, 5 nach der schmalbandigen Filterung nach der Zeit aufgetragen mit deutlich verringerter Amplitude vorliegen.

Der nächste Schritt ist in der zweiten Zeile im Schritt ganz links abgebildet. Die Signale 2, 3, 4, 5 werden verstärkt und im nächsten Schritt, dem zweiten Bild von links, mit einem Schwellenwert 4' für die Amplitude A verglichen. Es zeigt sich, dass lediglich das Signal 3 den Schwellenwert 4' für die Amplitude A überschreitet. Dieses Signal 3 wird im nächsten Schritt einem Kippstufenausgang zugeführt. Durch den Kippstufenausgang wird aus dem Signal ein binäres Signal, d. h. eine 0/1- bzw. ja/nein-Informationen 7, die angibt, ob eine Teilentladung vorgelegen hat oder nicht. Es erfolgt also beim erfindungsgemäßen Verfahren keine aufwändige Mustererkennung wie bei bisherigen Verfahren zur Erkennung von Teilentladungen.

Im letzten Schritt, dem vierten Bild von links in der zweiten Reihe, wird mittels eines Halteglieds die Ausgabedauer des Signals 43 auf den Sekundenbereich ausgedehnt. Die ermöglicht eine Anzeige mit einfachen mechanischen oder elektronischen Anzeigeeinrichtungen.

Im Ergebnis wird durch den Einsatz des schmalbandigen Filters ein Kompromiss zwischen möglicher Signalstärke nach der Filterung und dem Herausfiltern möglichst vieler Störungen erreicht. Wird beispielsweise ein Teil aller in der GIS auftretenden Teilentladungen, also z.B. 3-5 % der Teilentladungen, erfasst, so können davon durch das erfindungsgemäße Verfahren nach einer Filterung z.B. noch die Hälfte der Teilentladungen erkannt und angezeigt werden. Dies ist aber für den Einsatz unter realen Bedingungen kein Problem, weil der einfache und kostengünstige Ansatz des erfindungsgemäßen Verfahrens periodisch immer wiederkehrende Teilentladungen erkennt und dem Fachmann bzw. Wartungspersonal diese Information anzeigt.

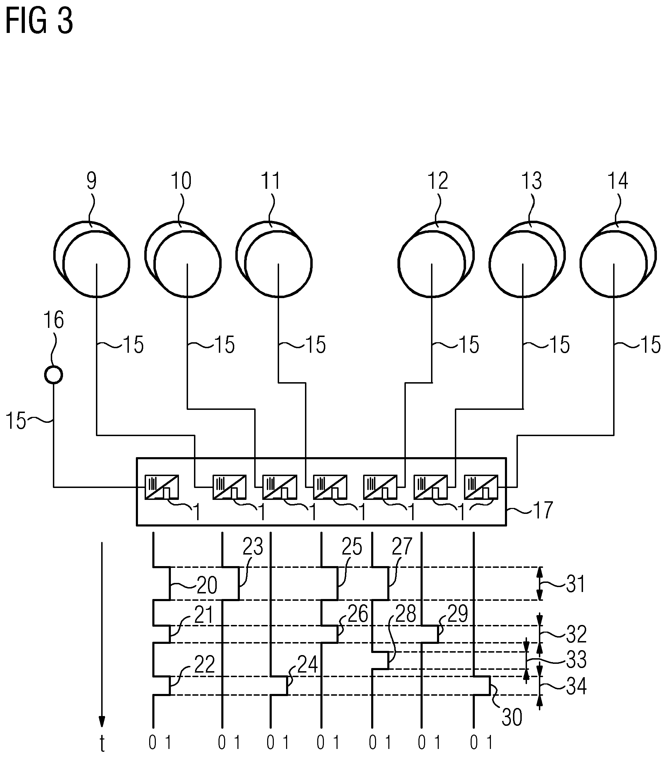

Die Figur 3 zeigt ein erstes Ausführungsbeispiel für den Einsatz interner und externer Antennen bei einer gasisolierten Schaltanlage. Es werden sechs interne Antennen 9-14 eingesetzt. Weiterhin wird eine externe Antenne 16 eingesetzt, um von außen einwirkende elektromagnetische Strahlung zu erfassen und zur Auswertung und Erkennung von Störungen heranzuziehen. Die internen Antennen 9-14 befinden sich innerhalb einer gasisolierten Schaltanlage. Alle Antennen 9-14,16 sind über Leitungen 15 mit einer Auswertungsanordnung 17 verbunden. In der Auswertungsanordnung 17 wird für jede der Antennen 9-14,16 das erfindungsgemäße Verfahren 1 durchgeführt, wobei sich für die empfangenen Signale der Antennen 9-14,16 jeweils eine binäre Information darüber ergibt, ob Teilentladungen vorgelegen haben oder nicht. Das Vorliegen von Signalen, die auf eine internen Teilentladung hinweisen, ist jeweils in der Zeitdomäne und unterhalb der betreffenden internen Antennen 9-14 oder der externen Antenne 16 aufgetragen.

Es zeigt sich, dass die internen Antennen 10, 11, 12 sowie die externe Antenne 16 zur selben Zeit ein Signal 20,23,25,27 auffangen, das eine Teilentladung sein könnte. Da jedoch dieses Signal nicht nur intern, sondern auch über die externe Antenne 16 aufgefangen wurde, wird dieses Signal nicht als eine Teilentladung, sondern als eine externe Störquelle 31 bewertet. Zu einem späteren Zeitpunkt erfassen die internen Antennen 11, 13 die Signale 26, 29. Gleichzeitig erfasst aber die externe Antenne 16 ebenfalls ein Signal 21. Daher wird auch dieses Signal einer externen Störquelle 32 und nicht einer Teilentladung zugeordnet. In gleicher Weise ergibt sich aus den Signalen 22, 24, 30 eine weitere externe Störquelle 34. Solche externen Störquellen können beispielsweise Handysignale sein, die in einem benachbarten GHz-Frequenzbereich Funksignale aussenden.

Es gibt jedoch innerhalb der erfassten Zeitspanne ein Signal 28, das von der internen Antenne 12 erfasst wurde. Dieses Signal liegt bei keiner anderen internen oder externen Antenne vor. Daher wird dieses Signal 28 als eine Teilentladung 33 registriert und dem Nutzer angezeigt. Dieses Beispiel verdeutlicht, dass mittels des erfindungsgemäßen Verfahrens lediglich eine binäre Information darüber, ob eine Teilentladung vorliegt, ermittelt werden kann. Es erfolgt keine genauere Mustererkennung, mit deren Hilfe ein Experte weitere Details über die Teilentladungsursache erkennen könnte. Die ermöglicht schätzungsweise, mittels der erfindungsgemäßen Anordnung eine bis zu 50 % kostengünstigere Überwachung einer gasisolierten Schaltanlage bereitstellen zu können. Bisherige Systeme mit bis zu 100 Kanälen für z. B. 13 Felder einer gasisolierten Schaltanlage haben einen Marktpreis von 250 000 bis 300 000 Euro. Durch die Einsparung der digitalen Hardware und Signalverarbeitungskomponenten sowie der aufwendigen Verdrahtung und eines eingebauten PCs kann das hier vorgestellte vereinfachte Verfahren bzw. System deutlich kostengünstiger angeboten werden.

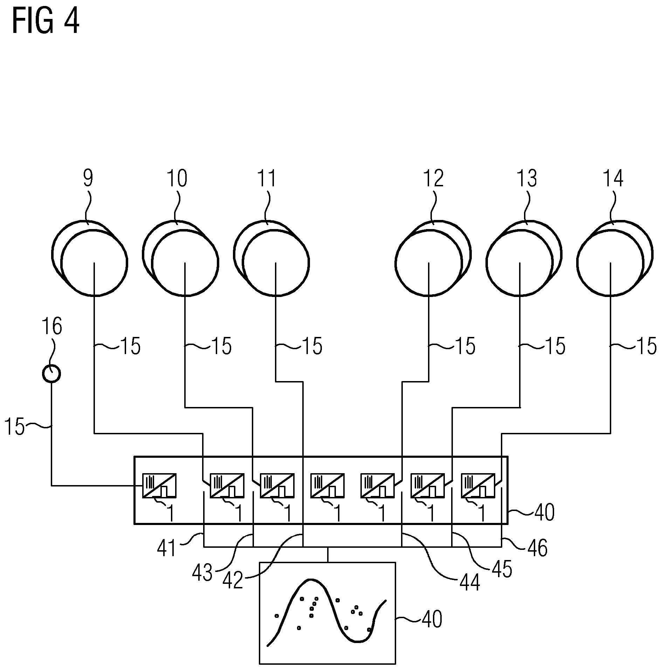

Die Figur 4 zeigt ein zweites Ausführungsbeispiel für den Einsatz interner und externer Antennen 9-14,16 bei einer gasisolierten Schaltanlage. In diesem Ausführungsbeispiel wird im Unterschied zum Ausführungsbeispiel gemäß Figur 3 eine Mustererkennungseinrichtung 40 zur Analyse von Teilentladungsdetails vorgesehen. Jede der internen Antennen erhält zusätzlich einen Anschluss 41-46, der über einen Schalter mit der internen Antenne 9-14 verbunden ist. Im dargestellten Beispiel sind die Antennen 9, 11, 12, 13, 14 jeweils in der Mustererkennungseinrichtung 40 derart geschaltet, dass eine Auswertung mittels des vereinfachten erfindungsgemäßen Verfahrens 1 erfolgt. Lediglich die interne Antenne 11 ist über ihren Anschluss 42 mit der Mustererkennungseinrichtung 40 verbunden. Auf diese Weise kann eine bei der Antenne 11 erkannte interne Teilentladung beispielsweise mittels der Mustererkennungseinrichtung 40 genauer analysiert werden, um eine Fehlerursache zu identifizieren. Dies kann beispielsweise derart erfolgen, dass zunächst alle internen Antennen mit dem vereinfachten Verfahren 1 ausgewertet werden. Es ergeben sich durch den Vergleich mit der externen Antenne wie eingangs erläutert binäre Signale, die entweder als Teilentladung oder als externe Störquelle identifiziert werden. Wird nun beispielsweise bei der Antenne 11 eine Teilentladung registriert, so kann die Antenne 11 über den Anschluss 42 auf die Mustererkennungseinrichtung 40 geschaltet werden, um periodisch später auftretende Teilentladungen einer genaueren Analyse zu unterziehen. Dieser Ansatz ist sehr kostengünstig, weil der Verdrahtungsaufwand minimiert wird und die notwendige Hardware für eine rechentechnisch aufwändige Mustererkennung, z.B. unter Heranziehung eines sog. Point-on-Wave Verfahrens, nur einmal vorgesehen wird.

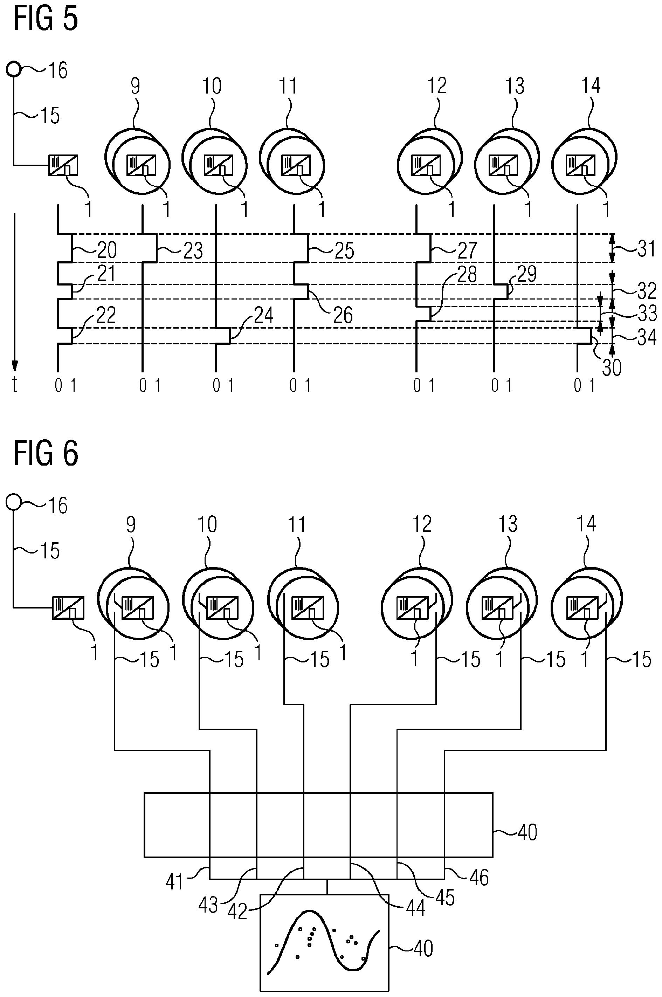

Die Figur 5 zeigt ein drittes Ausführungsbeispiel für den Einsatz interner und externer Antennen 9-14,16 bei einer gasisolierten Schaltanlage. Im Unterschied zu den vorherigen Beispielen wird hier jedoch zur Minimierung von Störeinflüssen und Signaldämpfung durch die eingesetzten Kabel 15 eine andere Bauweise bevorzugt. Die internen Antennen 9-14 werden derart ausgerüstet, dass das erfindungsgemäße Verfahren 1 direkt in oder an den Anschlussboxen der internen Antennen installiert werden kann.

Die Figur 6 zeigt ein viertes Ausführungsbeispiel für den Einsatz interner und externer Antennen bei einer gasisolierten Schaltanlage. In diesem Beispiel wird wie bei dem Ausführungsbeispiel gemäß Figur 5 eine binäre Auswertung empfangener elektromagnetischer Wellen bei den internen Antennen 9-14 vorgenommen. Die internen Antennen 9-14 verfügen aber nun ebenfalls über eine Schalteinrichtung wie in Figur 4, sodass eine Mustererkennungseinrichtung 40 zugeschaltet werden kann. In diesem Beispiel ist die interne Antenne 11 mit der Mustererkennungseinrichtung 40 verbunden. Auf diese Weise kann auch bei einer Verwendung des erfindungsgemäßen Verfahrens direkt innerhalb der Anschlussboxen der internen Antennen eine genaue Auswertung und Analyse von Fehlerursachen einer Teilentladung erfolgen.

## Patentansprüche

1. Verfahren (1) zum Erkennen von Teilentladungen (33) bei einem elektrischen Betriebsmittel, bei dem
mittels einer Sensoreinrichtung (9-14) elektromagnetische Impulse (2-5) erfasst werden,
wobei mittels einer Filtereinrichtung ein schmales Frequenzband (7) aus einem Frequenzspektrum der elektromagnetischen Impulse ausgewählt wird, und
mittels einer Verstärkereinrichtung das schmale Frequenzband jeweils verstärkt wird, und
mittels einer Auswerteeinrichtung in dem schmalen Frequenzband enthaltene Signale mit einem Schwellenwert (41) für die Amplitude (A) verglichen werden, wobei bei Überschreiten des Schwellenwertes (41) eine Teilentladung (33) erkannt wird,
**dadurch gekennzeichnet dass** das Signal einer erkannten Teilentladung (3) mittels eines Kippstufenausgangs in ein digitales Signal (42) umgewandelt wird,
wobei als Kippstufenausgang ein Schmitt-Trigger verwendet wird.

2. Verfahren (1) nach einem der vorhergehenden Ansprüche, **dadurch gekennzeichnet, dass** ein Halteglied zum Verlängern der Zeitdauer des digitalen Signals (43) eingesetzt wird.

3. Verfahren (1) nach einem der vorhergehenden Ansprüche, **dadurch gekennzeichnet, dass** für die Sensoreinrichtung, die Filtereinrichtung, die Verstärkereinrichtung, den Kippstufenausgang, das gegebenenfalls enthaltene Halteglied und die Auswerteeinrichtung jeweils analoge elektrische Schaltungen verwendet werden.

4. Verfahren (1) nach einem der vorhergehenden Ansprüche, **dadurch gekennzeichnet, dass** die elektromagnetischen Impulse in einem Frequenzbereich bis 2 GHz erfasst werden und dass für das schmale Frequenzband eine Frequenzbreite von höchstens 200 MHz verwendet wird.

5. Verfahren (1) nach einem der vorhergehenden Ansprüche, **dadurch gekennzeichnet, dass** für das Betriebsmittel eine gasisolierte elektrische Schaltanlage verwendet wird.

6. Anordnung zum Erkennen von Teilentladungen (33) bei einem elektrischen Betriebsmittel, aufweisend
eine Sensoreinrichtung (9-14) zur Erfassung von elektromagnetischen Signalen,
wobei eine Filtereinrichtung, die dazu ausgebildet ist, ein schmales Frequenzband (7) aus einem Frequenzspektrum der elektromagnetischen Signale auszuwählen, und
eine Verstärkereinrichtung, die dazu ausgebildet ist, das schmale Frequenzband (7) jeweils zu verstärken, und
eine Auswerteeinrichtung, die dazu ausgebildet ist, in dem schmalen Frequenzband (7) enthaltene Signale mit einem Schwellenwert (41) für die Amplitude zu vergleichen, wobei bei Überschreiten des Schwellenwertes (41) eine Teilentladung (33) erkannt wird,
**dadurch gekennzeichnet dass** ein Kippstufenausgang vorgesehen ist, der dafür ausgebildet ist, eine Teilentladung in ein digitales Signal (42) umzuwandeln,
wobei als Kippstufenausgang einen Schmitt-Trigger aufweist.

7. Anordnung nach Anspruch 6, **dadurch gekennzeichnet, dass** ein Halteglied zum Verlängern der Zeitdauer des digitalen Signals (43) vorgesehen ist.

8. Anordnung nach einem der Ansprüche 6 bis 7, **dadurch gekennzeichnet, dass** die Sensoreinrichtung, die Filtereinrichtung, die Verstärkereinrichtung, den Kippstufenausgang, das gegebenenfalls enthaltene Halteglied und die Auswerteeinrichtung jeweils als analoge elektrische Schaltungen ausgebildet sind.

9. Anordnung nach einem der Ansprüche 6 bis 8, **dadurch gekennzeichnet, dass** die elektromagnetischen Impulse einen Frequenzbereich von bis zu 2 GHz aufweisen und dass das schmale Frequenzband eine Frequenzbreite von höchstens 200 MHz aufweist.

10. Anordnung nach einem der Ansprüche 6 bis 9, **dadurch gekennzeichnet, dass** das Betriebsmittel eine gasisolierte elektrische Schaltanlage aufweist.

## Claims

1. Method (1) for detecting partial discharges (33) for an electrical apparatus, in which
a sensor device (9-14) is used to capture electromagnetic pulses (2-5),
wherein
a filter device is used to select a narrow frequency band (7) from a frequency spectrum of the electromagnetic pulses, and an amplifier device is used to amplify the narrow frequency band each time, and
an evaluation device is used to compare signals contained in the narrow frequency band with a threshold value (41) for the amplitude (A), wherein a partial discharge (33) is detected if the threshold value (41) is exceeded,
**characterized in that** the signal of a detected partial discharge (3) is converted into a digital signal (42) by means of a flipflop output,
wherein the flipflop output used is a Schmitt trigger.

2. Method (1) according to Claim 1, **characterized in that** a sample-and-hold element is used to extend the duration of the digital signal (43).

3. Method (1) according to either of the preceding claims, **characterized in that** analogue electrical circuits are used each time for the sensor device, the filter device, the amplifier device, the flipflop output, the possibly included sample-and-hold element and the evaluation device.

4. Method (1) according to one of the preceding claims, **characterized in that** the electromagnetic pulses are captured in a frequency range up to 2 GHz and **in that** a frequency width of no more than 200 MHz is used for the narrow frequency band.

5. Method (1) according to one of the preceding claims, **characterized in that** a gas-insulated electrical switchgear unit is used for the apparatus.

6. Arrangement for detecting partial discharges (33) for an electrical apparatus, having
a sensor device (9-14) for capturing electromagnetic signals, wherein
a filter device designed to select a narrow frequency band (7) from a frequency spectrum of the electromagnetic signals, and an amplifier device designed to amplify the narrow frequency band (7) each time, and
an evaluation device designed to compare signals contained in the narrow frequency band (7) with a threshold value (41) for the amplitude, wherein a partial discharge (33) is detected if the threshold value (41) is exceeded,
**characterized in that** there is provision for a flipflop output designed to convert a partial discharge into a digital signal (42),
wherein the flipflop output comprises a Schmitt trigger.

7. Arrangement according to Claim 6, **characterized in that** there is provision for a sample-and-hold element for extending the duration of the digital signal (43).

8. Arrangement according to either of Claims 6 to 7, **characterized in that** the sensor device, the filter device, the amplifier device, the flipflop output, the possibly included sample-and-hold element and the evaluation device are each in the form of analogue electrical circuits.

9. Arrangement according to one of Claims 6 to 8, **characterized in that** the electromagnetic pulses have a frequency range of up to 2 GHz and **in that** the narrow frequency band has a frequency width of no more than 200 MHz.

10. Arrangement according to one of Claims 6 to 9, **characterized in that** the apparatus comprises a gas-insulated electrical switchgear unit.

## Revendications

1. Procédé (1) d'identification de décharges (33) partielles dans un moyen de fonctionnement électrique, dans lequel on détecte des impulsions (2-5) électromagnétiques, au moyen d'un dispositif (9-14) capteur,
dans lequel
au moyen d'un dispositif de filtrage, on sélectionne une bande (7) de fréquence étroite dans un spectre de fréquence des impulsions électromagnétiques, et
au moyen d'un dispositif amplificateur, on amplifie respectivement la bande de fréquence étroite, et
au moyen d'un dispositif d'évaluation, on compare, pour l'amplitude (A), des signaux contenus dans la bande de fréquence étroite à une valeur (41) de seuil, dans lequel, si la valeur (41) de seuil est dépassée, on identifie une décharge (33) partielle, **caractérisé en ce que** l'on transforme le signal d'une décharge (3) partielle identifiée en un signal (42) numérique, au moyen d'une sortie d'étage de relaxation,
dans lequel on utilise, comme sortie d'étage de relaxation, une bascule de Schmitt.

2. Procédé (1) suivant l'une des revendications précédentes, **caractérisé en ce que** l'on utilise un élément de maintien pour prolonger la durée du signal (43) numérique.

3. Procédé (1) suivant l'une des revendications précédentes, **caractérisé en ce que** l'on utilise, pour le dispositif capteur, le dispositif de filtrage, le dispositif amplificateur, la sortie d'étage de relaxation, l'élément de maintien contenu éventuellement et le dispositif d'évaluation, respectivement des circuits électriques analogiques.

4. Procédé (1) suivant l'une des revendications précédentes, **caractérisé en ce que** l'on détecte les impulsions électromagnétiques dans une fréquence allant jusqu'à 2 GHz et **en ce que** l'on utilise pour la bande de fréquence étroite une largeur de fréquence de 200 MHz au plus.

5. Procédé (1) suivant l'une des revendications précédentes, **caractérisé en ce que** l'on utilise, pour le moyen de fonctionnement, une installation de coupure électrique à isolation par du gaz.

6. Agencement d'identification de décharges (33) partielles dans un moyen de fonctionnement électrique, comportant un dispositif (9-14) capteur de détection de signaux électromagnétiques,
un dispositif de filtrage, qui est constitué pour sélectionner une bande (7) de fréquence étroite dans un spectre de fréquence des signaux électromagnétiques, et
un dispositif amplificateur, qui est constitué pour amplifier respectivement la bande (7) de fréquence étroite, et
un dispositif d'évaluation, qui est constitué pour comparer, pour l'amplitude, des signaux contenus dans la bande (7) de fréquence étroite à une valeur (41) de seuil, dans lequel, si la valeur (41) de seuil est dépassée, une décharge (33) partielle est identifiée, **caractérisé en ce qu'**il est prévu une sortie d'étage de relaxation, qui est constituée pour transformer une décharge partielle en un signal (42) numérique,
dans lequel la sortie d'étage de relaxation a une bascule de Schmitt.

7. Agencement suivant la revendication 6, **caractérisé en ce qu'**il est prévu un élément de maintien pour prolonger la durée du signal (43) numérique.

8. Agencement suivant l'une des revendications 6 à 7, **caractérisé en ce que** le dispositif capteur, le dispositif de filtrage, le dispositif amplificateur, la sortie d'étage de relaxation, l'élément de maintien contenu éventuellement et le dispositif d'évaluation sont constitués chacun sous la forme de circuits électriques analogiques.

9. Agencement suivant l'une des revendications 6 à 8, **caractérisé en ce que** les impulsions électromagnétiques ont une plage de fréquence allant jusqu'à 2 GHz et **en ce que** la bande de fréquence étroite a une largeur de fréquence de 200 MHz au plus.

10. Agencement suivant l'une des revendications 6 à 9, **caractérisé en ce que** le moyen de fonctionnement a une installation de coupure électrique à isolation par du gaz.
